# EUROPEAN PATENT APPLICATION

(11) **EP 4 845 325 A1**
(43) Date of publication of application: **25.11.2026**
(21) Application number: 26180385.2
(22) Date of filing: 21.05.2026
(51) Int. Cl.: H05K 7/20

(54) **COLD PLATES**

(30) Priority: 22.05.2025 US 202563810496 P; 15.03.2026 US 202619567249
(71) Applicant: Vertiv Corporation, Westerville, OH 43082 (US)
(72) Inventor: PAITHANE, Manoj J., Westerville, 43082 (US); NATARAJAN, Srinivasan, Westerville, 43082 (US)
(74) Representative: Ambroz, Simon

(57) **Abstract**

A cooling system can include a cold plate for thermally coupling to a heat load, a pump for circulating a cooling fluid through the cold plate, and a heat exchanger for rejecting the heat from the cooling fluid. The cold plate can extract heat from the heat load. The heat extracted from the heat load can be transferred to the cooling fluid circulating through the cold plate. The cold plate can include one or more channels for receiving cooling fluid flow therethrough and structure within the channel(s) for improving heat transfer to the cooling fluid.

## Description

### CROSS-REFERENCE TO RELATED APPLICATION(S)

This application claims the benefit of U.S. Provisional Patent Application No. 63/810,496 filed May 22, 2025, and U.S. Nonprovisional Patent Application No. 19/567,249 filed 15 March 2026.

### TECHNICAL FIELD

The present disclosure relates generally to cooling systems, such as those used with servers and server farms, and more specifically relates to cold plates for such cooling systems.

### BACKGROUND

Cold plates remove heat from mechanical and/or electrical equipment, such as computer processors, via liquid cooling. Liquid cooling is particularly useful in small spaces or other implementations where more traditional convection cooling is insufficient. However, conventional cold plates have limitations.

### SUMMARY

Applicant has created new and useful devices, systems and methods for cold plates used to cool mechanical and/or electrical equipment, such as computer processors, via liquid cooling. Boundary layers in liquid flow can inhibit effective heat transfer. In at least one example, a cold plate according to the disclosure can break the boundary layers near a heated surface and/or divert high speed liquid flow over the heated surface to carry heat from the heated surface and a heat source thermally coupled thereto. In at least one example, structure in one or more channels of a cold plate according to the disclosure can disturb, or agitate, liquid flow and/or otherwise break the boundary layers near an interior surface of the channel and/or divert high speed liquid flow over the interior surface to carry heat from the interior surface and a heat source thermally coupled thereto.

In at least one example, a cooling system according to the disclosure can include a cold plate for thermally coupling to a heat load, a pump for circulating a cooling fluid through the cold plate, a heat exchanger for rejecting the heat from the cooling fluid, or any combination thereof. In at least one example, the cold plate thermally coupled to the heat load can extract heat from the heat load. In at least one example, the heat extracted from the heat load can be transferred to the cooling fluid circulating through the cold plate. In at least one example, a cold plate according to the disclosure can include one or more channels for receiving cooling fluid flow therethrough and structure within the channel(s) for disturbing or disrupting flow of the cooling fluid to improve heat transfer to the cooling fluid.

In at least one example, the structure can extend from an interior surface of the channel, such as an interior surface adjacent to the heat load. In at least one example, the structure can be or include one or more ramped surfaces that slope away from the heat load along a flow path of the cooling fluid and/or across the flow path of the cooling fluid. In at least one example, the ramped surfaces can be evenly spaced along the flow path of the cooling fluid.

In at least one example, the structure can be or include one or more steps that extend from an interior surface of the channel adjacent to the heat load. In at least one example, the steps can have a uniform height from the interior surface of the channel adjacent to the heat load. In at least one example, the steps can have an apex oriented towards a fluid inlet and/or a fluid outlet of the channel. In at least one example, the steps can have one or more legs that extend from the apex at an angle with respect to the flow path of the cooling fluid. In at least one example, the step(s) and/or the leg(s) can extend rearwardly and/or forwardly of the apex with respect to the flow path. In at least one example, the steps can be evenly spaced along a flow path of the cooling fluid.

In at least one example, the structure can be or include one or more cones, which can include one or more apexes oriented towards a fluid inlet and/or a fluid outlet of the channel. In at least one example, the cones can have a circular and/or star-shaped cross-section. In at least one example, the cones can be mounted on arms extending from an interior surface of the channel adjacent to the heat load. In at least one example, the cones and/or the arms can be evenly spaced along the flow path of the cooling fluid.

In at least one example, the structure can be or include one or more fins extending inwardly from an interior surface of the channel. In at least one example, the fins can extend inwardly around an interior perimeter of the channel. In at least one example, the fins can extend inwardly from all around the interior surface of the channel. In at least one example, the fins can swirl the cooling fluid flowing through the channel. In at least one example, the fins can be angled with respect to a flow path of the cooling fluid, such as to induce rotation and/or swirl to the cooling fluid flowing through the channel. In at least one example, the fins can be evenly spaced along the flow path of the cooling fluid and/or around the interior perimeter of the channel.

In at least one example, the structure can be or include one or more ridges extending inwardly from an interior surface of the channel. In at least one example, the ridges can extend inwardly around an interior perimeter of the channel. In at least one example, the ridges can extend inwardly from all around the interior surface of the channel. In at least one example, the ridges can extend along the length of the channel, or a portion thereof. In at least one example, the ridges can be evenly spaced along the flow path of the cooling fluid and/or around the interior perimeter of the channel.

### BRIEF DESCRIPTION OF THE DRAWINGS

FIG. 1 is a diagram of one of many examples of a cooling system according to the disclosure.
FIG. 2 is a perspective view of one of many examples of a cold plate according to the disclosure.
FIG. 3 is a semi-transparent perspective view heat map of one of many examples of a cold plate channel without disruptive structure according to the disclosure.
FIG. 4 is a semi-transparent perspective view heat map of one of many examples of a cold plate channel with disruptive structure according to the disclosure.
FIG. 5 is a graph of temperatures along the channels of FIG. 3 and FIG. 4.
FIG. 6 is a semi-transparent perspective view of one of many examples of structure within a channel of a cold plate according to the disclosure.
FIG. 7 is a close-up perspective view of the structure of FIG. 6.
FIG. 8 is a velocity distribution map of airflow through a channel in the absence of structure according to the disclosure.
FIG. 9 is a velocity distribution map of airflow through a channel including one of many examples of structure according to the disclosure.
FIG. 10 is a sectional elevation view of another one of many examples of structure within a channel of a cold plate according to the disclosure.
FIG. 11 is a sectional plan view of the structure of FIG. 10.
FIG. 12 is a sectional side elevation view of yet another one of many examples of structure within a channel of a cold plate according to the disclosure.
FIG. 13 is a sectional plan view of the structure of FIG. 12.
FIG. 14 is a sectional front elevation view of the structure of FIG. 12.
FIG. 15 is a cross sectional view of still another one of many examples of structure within a channel of a cold plate according to the disclosure.
FIG. 16 is a cross sectional view of still another one of many examples of structure within a channel of a cold plate according to the disclosure.

### DETAILED DESCRIPTION

The figures described above and the written description of specific structures and functions below are not presented to limit the scope of what Applicant has invented or the scope of the appended claims. Rather, the figures and written description are provided to teach any person skilled in the art to make and use the inventions for which patent protection is sought. Those skilled in the art will appreciate that not all features of a commercial example of the inventions are described or shown for the sake of clarity and understanding. Persons of skill in this art will also appreciate that the development of an actual commercial example incorporating aspects of the present inventions will require numerous implementation-specific decisions to achieve the developer's ultimate goal for the commercial example. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the inventions or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Any process flowcharts discussed herein illustrate the operation of possible implementations of systems and methods according to various examples of the present disclosure. Each block in a flowchart may represent a module, segment, or portion of one or more of such implementations. In some implementations, the subject matter noted in the block(s) might occur out of the order depicted in the figures. For example, blocks shown in succession may, in fact, be executed substantially concurrently.

Applicant has created new and useful devices, systems and methods for cold plates used to cool mechanical and/or electrical equipment, such as computer processors, via liquid cooling. Boundary layers in liquid flow can inhibit effective heat transfer. In at least one example, a cold plate according to the disclosure can break the boundary layers near a heated surface and/or divert high speed liquid flow over the heated surface to carry heat from the heated surface and a heat source thermally coupled thereto. In at least one example, structure in one or more channels of a cold plate according to the disclosure can disturb, or agitate, liquid flow and/or otherwise break the boundary layers near an interior surface of the channel and/or divert high speed liquid flow over the interior surface to carry heat from the interior surface and a heat source thermally coupled thereto.

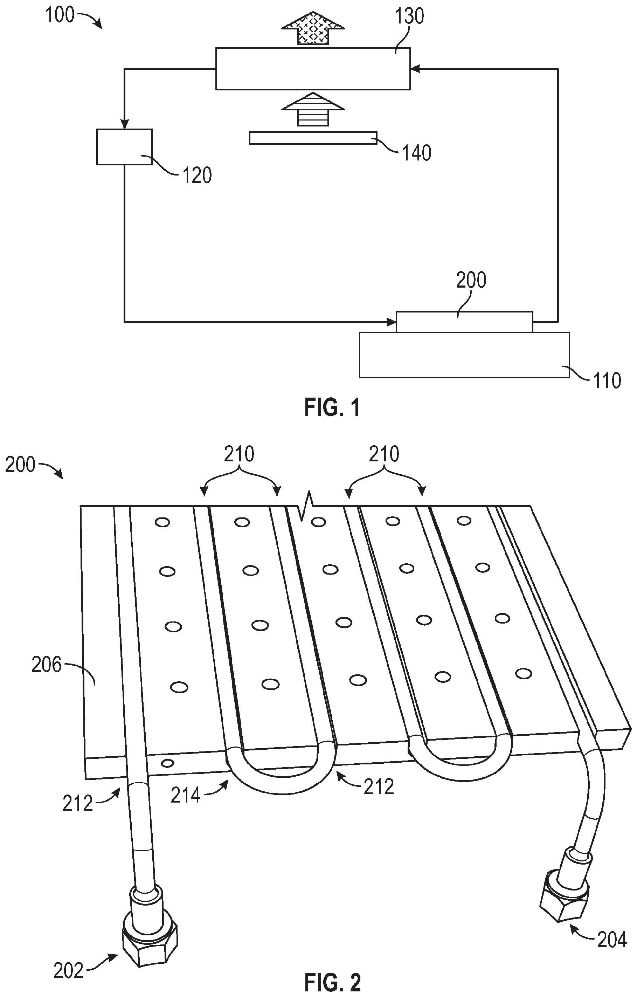

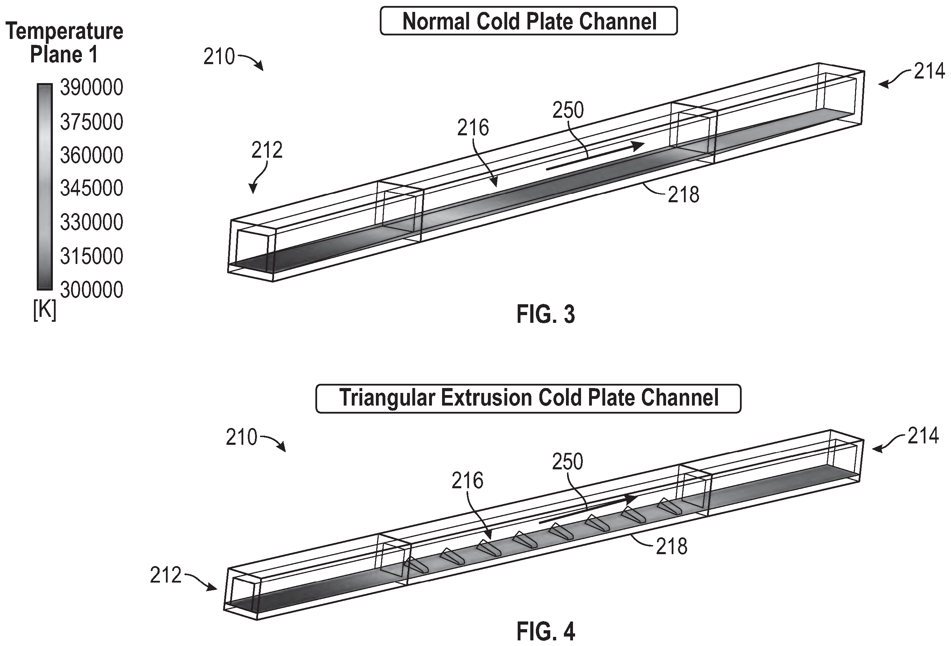

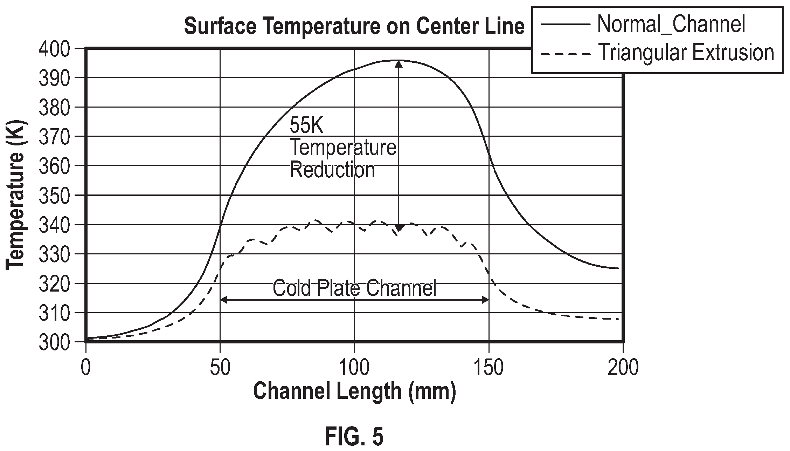

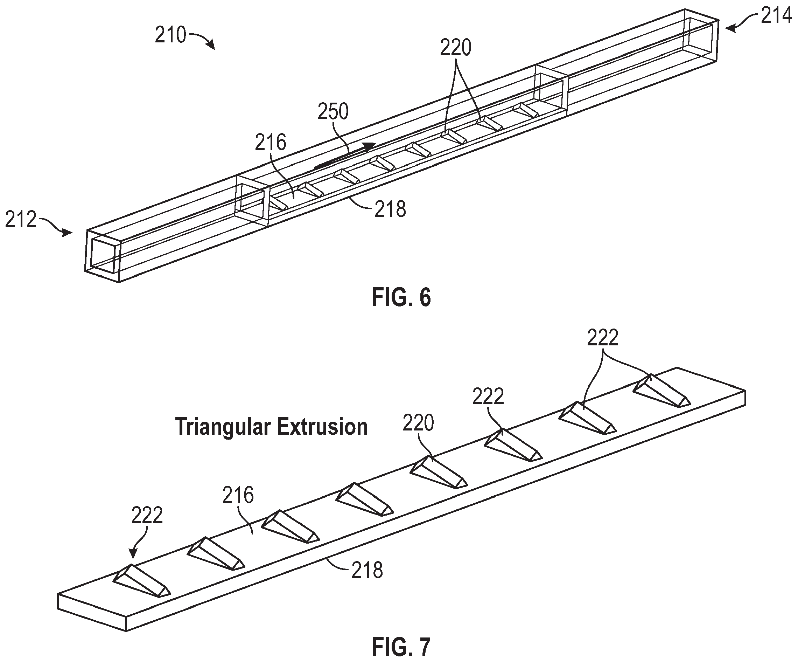

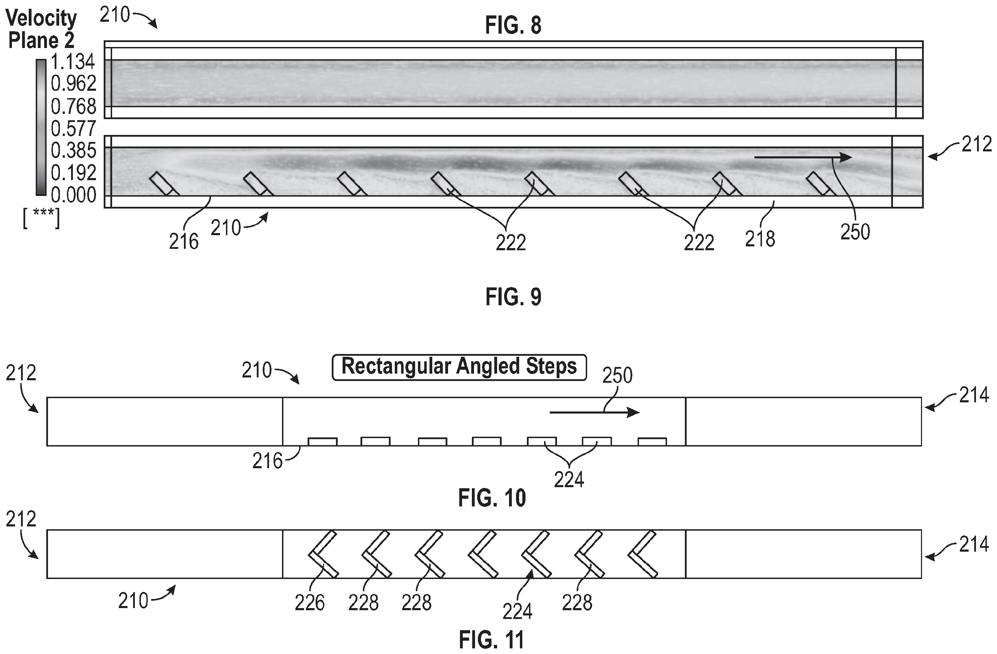

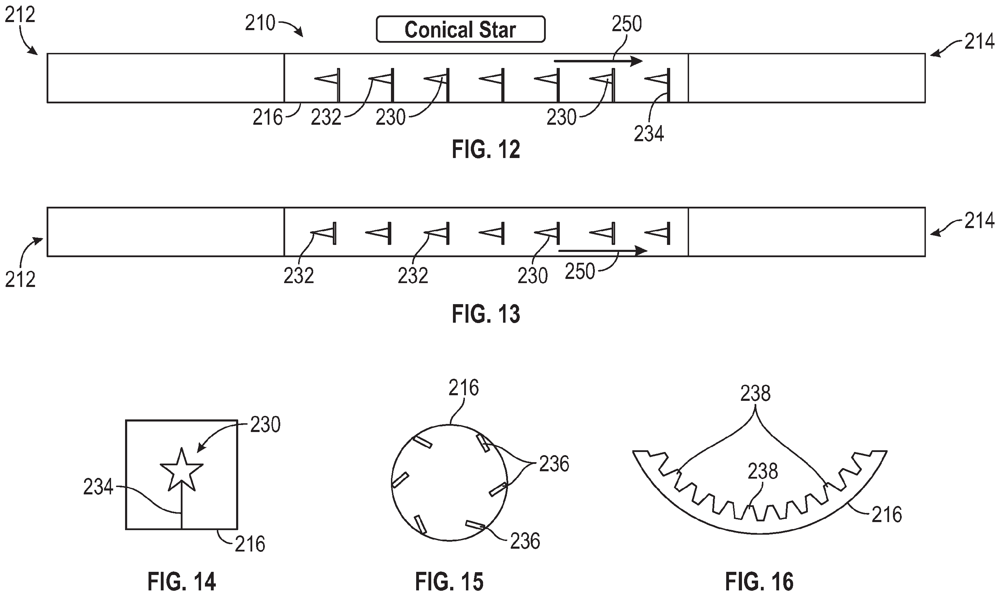

FIG. 1 is a diagram of one of many examples of a cooling system according to the disclosure. FIG. 2 is a perspective view of one of many examples of a cold plate according to the disclosure. FIG. 3 is a semi-transparent perspective view heat map of one of many examples of a cold plate channel without disruptive structure according to the disclosure. FIG. 4 is a semi-transparent perspective view heat map of one of many examples of a cold plate channel with disruptive structure according to the disclosure. FIG. 5 is a graph of temperatures along the channels of FIG. 3 and FIG. 4. FIG. 6 is a semi-transparent perspective view of one of many examples of structure within a channel of a cold plate according to the disclosure. FIG. 7 is a close-up perspective view of the structure of FIG. 6. FIG. 8 is a velocity distribution map of airflow through a channel in the absence of structure according to the disclosure. FIG. 9 is a velocity distribution map of airflow through a channel including one of many examples of structure according to the disclosure. FIG. 10 is a sectional elevation view of another one of many examples of structure within a channel of a cold plate according to the disclosure. FIG. 11 is a sectional plan view of the structure of FIG. 10. FIG. 12 is a sectional side elevation view of yet another one of many examples of structure within a channel of a cold plate according to the disclosure. FIG. 13 is a sectional plan view of the structure of FIG. 12. FIG. 14 is a sectional front elevation view of the structure of FIG. 12. FIG. 15 is a cross sectional view of still another one of many examples of structure within a channel of a cold plate according to the disclosure. FIG. 16 is a cross sectional view of still another one of many examples of structure within a channel of a cold plate according to the disclosure. FIGS. 1-16 are described in conjunction with one another.

In at least one example, a cooling system 100 according to the disclosure can include one or more cold plates 200 for thermally coupling to one or more heat loads 110, one or more pumps 120 for circulating a cooling fluid through the cold plate(s) 200, one or more heat exchangers 130 for rejecting the heat from the cooling fluid, or any combination thereof. In at least one example, the system 100 can include a compressor in addition to, or instead of, the pump 120. In at least one example, the system 100 can include one or more control valves, sensors, controllers, or any combination thereof. In at least one example, the heat exchanger 130 can be or include one or more fluid-to-fluid heat exchangers, such as a brazed plate heat exchanger (BPHE), and/or one or more fluid-to-air heat exchangers, such as a condenser, cooling tower, dry cooler, etc. In at least one example, such as where the heat exchanger 130 includes a fluid-to-air heat exchanger, the system 100 can include a fan 140 to direct air to and/or through the heat exchanger 130.

In at least one example, the cold plate 200 thermally coupled to the heat load can extract heat from the heat load 110. In at least one example, the heat load 110 can be or include one or more mechanical devices or systems, such as a refrigeration system, an air conditioning system, a motor, or any combination thereof. In at least one example, the heat load 110 can be or include one or more electrical devices or systems, such as a power generation and/or distribution system, a computer processor, a computer networking device, or any combination thereof. In at least one example, the heat extracted from the heat load 110 can be transferred to the cooling fluid circulating through the cold plate 200.

In at least one example, a cold plate 200 according to the disclosure can include one or more inlets 202, one or more outlets 204, one or more exterior surfaces 206, or any combination thereof. In at least one example, one or more surfaces 206 of the cold plate 200 can be thermally coupled to the heat load 110, such as by being in physical contact with the heat load 110 and/or by being disposed adjacent, or closest to, the head load 110. In at least one example, heat from the heat load 110 can be extracted therefrom through the surface 206 of the cold plate 200 thermally coupled to the heat load 110, in physical contact with the heat load 110, disposed adjacent, or closest to, the head load 110, or any combination thereof.

In at least one example, the cold plate 200 can include one or more channels 210 for receive cooling fluid flow therethrough. In at least one example, the channels 210 can have a cross-section that is rectangular, circular, triangular, oblong, elliptical, or any combination thereof. In at least one example, the channels 210 can be plumbed in parallel and/or series with one another. In at least one example, each channel 210 can include one or more inlets 212, one or more outlets 214, one or more interior surfaces 216, walls 218, or any combination thereof. In at least one example, one or more surfaces 216 of the channel 210 can be thermally coupled to the heat load 110, such as by being disposed adjacent, or closest to, the head load 110. In at least one example, heat from the heat load 110 can be extracted therefrom through the surface 216 of the channel 210 thermally coupled to the heat load 110, such as through the wall 218 thermally coupled to the heat load 110, in physical contact with the heat load 110, disposed adjacent, or closest to, the head load 110, or any combination thereof.

Cooling fluid flowing through the channel 210 can extract heat from the surface 216 of the channel 210 thermally coupled to the heat load 110, such as through the wall 218. Cooling fluid flowing smoothly through the channel 210 can be laminar, with different layers being of differing temperatures. For example, a boundary layer, adjacent, or closes to, the surface 216 of the channel 210 thermally coupled to the heat load 110 can be hotter than a layer further from the surface 216. This can result in inefficient extraction of heat from the heat load 110. This can also result in localized heat concentration along the surface 216 of the channel 210 thermally coupled to the heat load 110, such as shown in FIG. 3, for example.

In at least one example, each channel 210 can include structure 220 within the channel(s) 210 for disturbing or disrupting a flow of the cooling fluid therethrough. In at least one example, the structure 220 can disturb, agitate, swirl, or otherwise disrupt the flow and/or otherwise break the boundary layers near the surface 216 of the channel 210. In at least one example, the structure 220 can distribute the heat extracted from the heat load 110 throughout a cross section of the cooling fluid flowing through the channel 210, such as by disturbing, agitating, swirling, and/or otherwise mixing the cooling fluid as it flows through the channel 210.

In at least one example, the structure 220 can divert high speed liquid flow over the surface 216 to carry heat from the surface 216 and the heat load 110 thermally coupled thereto. In at least one example, the structure 220 can divert colder cooling fluid into contact with the surface 216 heated by the heat load 110. In at least one example, the structure 220 can divert cooling fluid to disrupt, minimize, move, remove, or any combination thereof air pockets, layers, bubbles, or any combination thereof that may form within the channel 210, such as near the surface 216. In at least one example, the structure 220 can divert colder cooling fluid into hotter layers of the cooling fluid to disrupt, minimize, move, mix with, or any combination thereof the hotter cooling fluid within the channel 210. This can result in the heat being distributed along the surface 216 of the channel 210 and/or through the cross-section of the channel 210, such as shown in FIG. 4, for example, which can improve the efficient extraction of heat from the heat load 110. As shown in FIG. 5, for example, a temperature of the cooling fluid and/or the channel 210 can be more uniform and/or lower in a channel 210 having the structure 220 therein to mixing the cooling fluid and/or otherwise better distribute the heat extracted from the heat load 110, than a channel 210 without the structure 220.

In at least one example, the structure 220 can extend from the interior surface 216 and/or wall 218 of the channel 210, such as an interior surface 216 adjacent, or closest to, the heat load 110. In at least one example, the structure 220 can be or include one or more ramped surfaces 222 that slope away from the heat load 110, and/or the surface 216 adjacent, or closest to, the heat load 110, along a flow path 250 of the cooling fluid and/or across the flow path 250 of the cooling fluid through the channel 210. In at least one example, the ramped surfaces 222 can be evenly spaced along the flow path 250 of the cooling fluid through the channel 210, or any portion thereof.

In at least one example, the structure 220 can be or include one or more steps 224 that extend from the surface 216 of the channel 210 adjacent to the heat load 110. In at least one example, the steps 224 can have a variable and/or uniform height from the surface 216 of the channel 210 adjacent to the heat load 110. In at least one example, the steps 224 can extend into the channel 210, from the surface 216, variable and/or uniform distance. In at least one example, the steps 224 can have an apex 226 oriented towards the fluid inlet 212 and/or the fluid outlet 214 of the channel 210. In at least one example, the steps 224 can have one or more legs 228 that can extend from the apex 226 at an angle with respect to the flow path 250 of the cooling fluid through the channel 210. In at least one example, the step(s) 224 and/or the leg(s) 228 can extend rearwardly and/or forwardly of the apex 226 with respect to the flow path 250. In at least one example, the steps 224 can be evenly spaced along a flow path 250 of the cooling fluid through the channel 210, or any portion thereof.

In at least one example, the structure 220 can be or include one or more cones 230, which can include one or more apexes 232 oriented towards the fluid inlet 212 and/or the fluid outlet 214 of the channel 210. In at least one example, the cones 230 can have a circular and/or star-shaped cross-section. In at least one example, the cones 230 can be mounted on arms 232 extending from the surface 216 of the channel 210 adjacent to the heat load 210. In at least one example, the cones 230 and/or the arms 232 can be evenly spaced along the flow path 250 of the cooling fluid through the channel 210, or any portion thereof.

In at least one example, the structure 220 can be or include one or more fins 236 extending inwardly from the surface 216 of the channel 210. In at least one example, the fins 236 can extend inwardly around an interior perimeter of the channel 210. In at least one example, the fins 236 can extend inwardly from all around the interior surface 216 of the channel 210, such as where the channel 210 has a circular cross-section. In at least one example, the fins 236 can swirl the cooling fluid flowing through the channel 210. In at least one example, the fins 236 can be angled with respect to the flow path 250 of the cooling fluid through the channel 210, such as to induce rotation and/or swirl to, or otherwise mix, the cooling fluid flowing through the channel 210. In at least one example, the fins 236 can be evenly spaced along the flow path 250 of the cooling fluid and/or around the interior perimeter of the channel 210, or any portion thereof.

In at least one example, the structure 220 can be or include one or more ridges 238 extending inwardly from the surface 216 of the channel 210. In at least one example, the ridges 238 can extend inwardly around an interior perimeter of the channel 210. In at least one example, the ridges 238 can extend inwardly from all around the interior surface 216 of the channel 210, such as where the channel 210 has a circular cross-section. In at least one example, the ridges 238 can extend along the length of the channel 210, or just a portion thereof. In at least one example, the ridges 238 can be evenly spaced along the flow path 250 of the cooling fluid and/or around the interior perimeter of the channel 210, or any portion thereof. In at least one example, the ridges 238 can twist around the interior perimeter of the channel 210, or any portion thereof, like rifling, and/or induce rotation to, or otherwise mix, the cooling fluid flowing through the channel 210.

In at least one example, a cooling system according to the disclosure can include a cold plate for thermally coupling to a heat load, a pump for circulating a cooling fluid through the cold plate, a heat exchanger for rejecting the heat from the cooling fluid, or any combination thereof. In at least one example, the cold plate thermally coupled to the heat load can extract heat from the heat load. In at least one example, the heat extracted from the heat load can be transferred to the cooling fluid circulating through the cold plate. In at least one example, a cold plate according to the disclosure can include one or more channels for receiving cooling fluid flow therethrough and structure within the channel(s) for disturbing or disrupting a flow of the cooling fluid therethrough.

In at least one example, the structure can extend from an interior surface of the channel, such as an interior surface adjacent to the heat load. In at least one example, the structure can be or include one or more ramped surfaces that slope away from the heat load along a flow path of the cooling fluid and/or across the flow path of the cooling fluid. In at least one example, the ramped surfaces can be evenly spaced along the flow path of the cooling fluid.

In at least one example, the structure can be or include one or more steps that extend from an interior surface of the channel adjacent to the heat load. In at least one example, the steps can have a uniform height from the interior surface of the channel adjacent to the heat load. In at least one example, the steps can have an apex oriented towards a fluid inlet and/or a fluid outlet of the channel. In at least one example, the steps can have one or more legs that extend from the apex at an angle with respect to the flow path of the cooling fluid. In at least one example, the step(s) and/or the leg(s) can extend rearwardly and/or forwardly of the apex with respect to the flow path. In at least one example, the steps can be evenly spaced along a flow path of the cooling fluid.

In at least one example, the structure can be or include one or more cones, which can include one or more apexes oriented towards a fluid inlet and/or a fluid outlet of the channel. In at least one example, the cones can have a circular and/or star-shaped cross-section. In at least one example, the cones can be mounted on arms extending from an interior surface of the channel adjacent to the heat load. In at least one example, the cones and/or the arms can be evenly spaced along the flow path of the cooling fluid.

In at least one example, the structure can be or include one or more fins extending inwardly from an interior surface of the channel. In at least one example, the fins can extend inwardly around an interior perimeter of the channel. In at least one example, the fins can extend inwardly from all around the interior surface of the channel. In at least one example, the fins can swirl the cooling fluid flowing through the channel. In at least one example, the fins can be angled with respect to a flow path of the cooling fluid, such as to induce rotation and/or swirl to the cooling fluid flowing through the channel. In at least one example, the fins can be evenly spaced along the flow path of the cooling fluid and/or around the interior perimeter of the channel.

In at least one example, the structure can be or include one or more ridges extending inwardly from an interior surface of the channel. In at least one example, the ridges can extend inwardly around an interior perimeter of the channel. In at least one example, the ridges can extend inwardly from all around the interior surface of the channel. In at least one example, the ridges can extend along the length of the channel, or just a portion thereof. In at least one example, the ridges can be evenly spaced along the flow path of the cooling fluid and/or around the interior perimeter of the channel.

In at least one example, a cold plate according to the disclosure can include a plurality of channels configured to receive cooling fluid flow therethrough, and structure disposed within the channels and configured to disrupt a flow of the cooling fluid therethrough. The structure can extend from an interior surface of the channel adjacent to the heat load. The structure can include a plurality of ramped surfaces that slope away from the heat load along a flow path of the cooling fluid. The ramped surfaces can be evenly spaced along the flow path of the cooling fluid. In at least one example, the structure can include a plurality of ramped surfaces that slope away from the heat load across a flow path of the cooling fluid, and the ramped surfaces can be evenly spaced along the flow path of the cooling fluid.

In at least one example, the structure can include a plurality of steps that extend from an interior surface of the channel adjacent to the heat load. In at least one example, the steps can be evenly spaced along a flow path of the cooling fluid. In at least one example, the steps can have a uniform height from the interior surface of the channel adjacent to the heat load. In at least one example, the steps can have an apex oriented towards a fluid inlet of the channel. In at least one example, the steps can have at least one leg that extends rearwardly of the apex at an angle with respect to the flow path of the cooling fluid.

In at least one example, a cold plate according to the disclosure can include structure disposed within the channels and configured to disrupt a flow of the cooling fluid, and the structure can include a plurality of cones having an apex oriented towards a fluid inlet of the channel. In at least one example, the cones can have a star-shaped cross section. In at least one example, the cones can be mounted on arms extending from an interior surface of the channel adjacent to the heat load.

In at least one example, a cold plate according to the disclosure can include structure disposed within the channels and configured to disrupt a flow of the cooling fluid, and the structure can include a plurality of fins extending inwardly from an interior surface of the channel. In at least one example, the fins can extend inwardly around an interior perimeter of the channel. In at least one example, the fins can be configured to swirl the cooling fluid flowing through the channel. In at least one example, the fins can be angled with respect to a flow path of the cooling fluid.

In at least one example, a cold plate according to the disclosure can include structure disposed within the channels and configured to disrupt a flow of the cooling fluid, and the structure can include a plurality of ridges extending inwardly from an interior surface of the channel. In at least one example, the ridges can extend inwardly around an interior perimeter of the channel.

The devices, systems and methods can be implemented for numerous different types and sizes in numerous different industries. Further, the various methods and examples of the devices, systems and methods can be included in combination with each other to produce variations of the disclosed methods and examples. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

The inventions have been described in the context of preferred and other examples and not every example of the inventions has been described. Obvious modifications and alterations to the described examples are available to those of ordinary skill in the art having the benefits of the present disclosure. The disclosed and undisclosed examples are not intended to limit or restrict the scope or applicability of the inventions conceived of by the Applicant, but rather, in conformity with the patent laws, Applicant intends to fully protect all such modifications and improvements that come within the scope or range of equivalents of the following claims.

Described herein are also the following clauses:
1. A cooling system comprising:
   a cold plate configured to be thermally coupled to a heat load;
   a pump configured to circulate a cooling fluid through the cold plate to transfer heat from the heat load to the cooling fluid; and
   a heat exchanger configured to reject the heat from the cooling fluid;
   wherein the cold plate includes a plurality of channels therethrough; and
   wherein one or more of the channels include structure disposed therein and configured to disrupt a flow of the cooling fluid therethrough.
2. The cooling system as set forth in clause 1, wherein the structure extends from an interior surface of the channel adjacent to the heat load.
3. The cooling system as set forth in any preceding clause, wherein the structure includes a plurality of ramped surfaces that slope away from the heat load along a flow path of the cooling fluid.
4. The cooling system as set forth in clause 3, wherein the ramped surfaces are evenly spaced along the flow path of the cooling fluid.
5. The cooling system as set forth in clause 1, wherein the structure includes a plurality of ramped surfaces that slope away from the heat load across a flow path of the cooling fluid.
6. The cooling system as set forth in clause 5, wherein the ramped surfaces are evenly spaced along the flow path of the cooling fluid.
7. The cooling system as set forth in clause 1, wherein the structure includes a plurality of steps that extend from an interior surface of the channel adjacent to the heat load.
8. The cooling system as set forth in clause 7, wherein the steps are evenly spaced along a flow path of the cooling fluid.
9. The cooling system as set forth in any preceding clause, wherein the steps have a uniform height from the interior surface of the channel adjacent to the heat load.
10. The cooling system as set forth in any clause 7 to 9, wherein the steps have an apex oriented towards a fluid inlet of the channel.
11. The cooling system as set forth in clause 10, wherein the steps have at least one leg that extends rearwardly of the apex at an angle with respect to the flow path of the cooling fluid.
12. The cooling system as set forth in clause 1, wherein the structure includes a plurality of cones having an apex oriented towards a fluid inlet of the channel.
13. The cooling system as set forth in clause 12, wherein the cones have a star-shaped cross section.
14. The cooling system as set forth in clause 12, wherein the cones are mounted on arms extending from an interior surface of the channel adjacent to the heat load.
15. The cooling system as set forth in clause 1, wherein the structure includes a plurality of fins extending inwardly from an interior surface of the channel.
16. The cooling system as set forth in clause 15, wherein the fins extend inwardly around an interior perimeter of the channel.
17. The cooling system as set forth in clause 15, wherein the fins are configured to swirl the cooling fluid flowing through the channel.
18. The cooling system as set forth in clause 15, wherein the fins are angled with respect to a flow path of the cooling fluid.
19. The cooling system as set forth in clause 1, wherein the structure includes a plurality of ridges extending inwardly from an interior surface of the channel.
20. The cooling system as set forth in clause 19, wherein the ridges extend inwardly around an interior perimeter of the channel.

## Claims

1. A cooling system comprising:
a cold plate configured to be thermally coupled to a heat load;
a pump configured to circulate a cooling fluid through the cold plate to transfer heat from the heat load to the cooling fluid; and
a heat exchanger configured to reject the heat from the cooling fluid;
wherein the cold plate includes a plurality of channels therethrough; and
wherein one or more of the channels include a structure disposed therein and configured to disrupt a flow of the cooling fluid therethrough.

2. The cooling system as set forth in claim 1, wherein the structure extends from an interior surface of the channel adjacent to the heat load.

3. The cooling system as set forth in any one of the preceding claims, wherein the structure includes a plurality of ramped surfaces that slope away from the heat load along a flow path of the cooling fluid.

4. The cooling system as set forth in claim 3, wherein the ramped surfaces are evenly spaced along the flow path of the cooling fluid.

5. The cooling system as set forth in claim 1, wherein the structure includes a plurality of ramped surfaces that slope away from the heat load across a flow path of the cooling fluid.

6. The cooling system as set forth in claim 5, wherein the ramped surfaces are evenly spaced along the flow path of the cooling fluid.

7. The cooling system as set forth in claim 1, wherein the structure includes a plurality of steps that extend from an interior surface of the channel adjacent to the heat load.

8. The cooling system as set forth in claim 7, wherein the steps are evenly spaced along a flow path of the cooling fluid.

9. The cooling system as set forth in any one of the claims 7 to 8, wherein the steps have a uniform height from the interior surface of the channel adjacent to the heat load.

10. The cooling system as set forth in any one of the claims 7 to 9, wherein the steps have an apex oriented towards a fluid inlet of the channel.

11. The cooling system as set forth in claim 10, wherein the steps have at least one leg that extends rearwardly of the apex at an angle with respect to the flow path of the cooling fluid.

12. The cooling system as set forth in claim 1, wherein the structure includes a plurality of cones having an apex oriented towards a fluid inlet of the channel;
optionally, wherein the cones have a star-shaped cross section;
and optionally, wherein the cones are mounted on arms extending from an interior surface of the channel adjacent to the heat load.

13. The cooling system as set forth in claim 1, wherein the structure includes a plurality of fins extending inwardly from an interior surface of the channel;
optionally, wherein the fins extend inwardly around an interior perimeter of the channel;
optionally, wherein the fins are configured to swirl the cooling fluid flowing through the channel;
and optionally, wherein the fins are angled with respect to a flow path of the cooling fluid.

14. The cooling system as set forth in claim 1, wherein the structure includes a plurality of ridges extending inwardly from an interior surface of the channel.

15. The cooling system as set forth in claim 14, wherein the ridges extend inwardly around an interior perimeter of the channel.
